# EUROPEAN PATENT APPLICATION

(11) **EP 2 524 897 A2**
(43) Date of publication of application: **21.11.2012**
(21) Application number: 12168498.9
(22) Date of filing: 18.05.2012
(51) Int. Cl.: B81B 7/00

(54) **Method and device for preventing corrosion on sensors**

(30) Priority: 19.05.2011 US 201113111619
(71) Applicant: General Electric Company, Schenectady, NY 12345 (US)
(72) Inventor: Wang, Qiang, Fremont, CA California 94539 (US); Jackson, Keith Matthew, Fremont, CA California 94539 (US); Mantravadi, Naresh Venkata, Fremont, CA California 94539 (US)
(74) Representative: Picker, Madeline Margaret

(57) **Abstract**

A device for preventing corrosion on sensors and a method of fabricating the same is disclosed, wherein the device comprises an insulation layer (400) and an adhesion layer (200) covering a metallization layer (300) of a silicon sensor with a corrosion resistant layer (100) located over the adhesion layer (200).

## Description

### BACKGROUND OF THE INVENTION

The subject matter disclosed herein relates to semiconductor microelectromechanical based sensors (MEMS) that can be used to detect small forces or flexures generated from mechanical stress, chemo-mechanical stress, thermal stress, electromagnetic fields, and the like. More particularly, the subject matter disclosed herein relates to a method and device for preventing corrosion on such sensors.

Advances in semiconductor microelectronic based sensors have served greatly to reduce the size and cost of such sensors. The electrical and mechanical properties of silicon microsensors have been well chronicled. Silicon micromachining and semiconductor microelectronic technologies have blossomed into a vital sensor industry with numerous practical applications. For instance, micromachined silicon pressure sensors, acceleration sensors, flow sensors, humidity sensors, microphones, mechanical oscillators, optical and RF switches and attenuators, microvalves, ink jet print heads, atomic force microscopy tips and the like are widely known to have found their way into various applications in high volume medical, aerospace, industrial and automotive markets. The high yield strength, elasticity at room temperature, and hardness properties of silicon makes it an ideal base material for resonant structures that may, for example, be useful for electronic frequency control or sensor structures. Even consumer items such as watches, scuba diving equipment and hand-held tire pressure gauges may incorporate silicon micromachined sensors.

The demand for silicon sensors in ever expanding fields of use continues to fuel a need for new and different silicon microsensor geometries and configurations optimized for particular environments and applications. Many applications require that these sensors operate within and be subjected to harsh environmental conditions, for example high humidity or acidic conditions, that can lead to corrosion of the metallization layer of the silicon sensor, for example the connections and wire bond pads that provide electrical conductivity to and from the sensor. Such corrosion can lead to sensor inaccuracies, malfunction, and even failure. To prevent such corrosion from occurring, some sensors utilize corrosion resistant solid gold metallization layers. However, gold is a soft metal susceptible to scratching and damage. Many sensors additionally utilize a glass layer bonded to a silicon substrate layer to insulate the device from its packaging. Use of gold metallization impacts traditional fabrication processes in that the gold metallization layer cannot be processed using wet etching techniques following completion of the silicon-to-glass bond. Further, processing the gold metallization layer prior to performing the silicon-to-glass bond would require techniques that degrade the quality of the bond in order to prevent diffusion of the gold into the silicon.

Therefore, there is a need for a low cost device and method for fabricating corrosion resistant electrical connections on silicon sensors that is not only durable, but that also facilitates the use of high quality silicon-to-glass bonding techniques.

The discussion above is merely provided for general background information and is not intended to be used as an aid in determining the scope of the claimed subject matter.

### BRIEF DESCRIPTION OF THE INVENTION

A device for preventing corrosion on sensors and a method of fabricating the same is disclosed, wherein the device comprises an insulation layer and an adhesion layer covering a metallization layer of a silicon sensor with a corrosion resistant layer located over the adhesion layer. An advantage that may be realized in the practice of some embodiments of the described device and method of fabrication is that it enables the use of conventional silicon-to-glass bonding techniques, while accommodating the use of gold as a corrosion resistant layer.

In one example embodiment, a method for preventing corrosion on sensors is disclosed. The method comprises the steps of depositing an insulation layer over a metallization layer of a sensor having substrate layer comprised of silicon, etching at least one contact channel through the insulation layer to expose a portion of the metallization layer, depositing an adhesion layer over a portion of the insulation layer and the interior surface of the at least one contact channel, the adhesion layer contacting a portion of the insulation layer and a portion of the metallization layer, and depositing a corrosion resistant layer over the adhesion layer.

In another example embodiment, a device for preventing corrosion on sensors is disclosed. The device comprises an insulation layer located over a metallization layer of a sensor having substrate layer comprised of silicon, at least one contact channel extending through the insulation layer to expose a portion of the metallization layer, an adhesion layer located over a portion of the insulation layer and the interior surface of the at least one contact channel, the adhesion layer contacting a portion of the insulation layer and a portion of the metallization layer, and a corrosion resistant layer located over the adhesion layer.

In another example embodiment, the device comprises an insulation layer comprising silicon dioxide located over a metallization layer comprising aluminum of a sensor having a substrate layer comprised of silicon, a glass layer bonded to the bottom of the substrate layer, at least one contact channel extending through the insulation layer to expose a portion of the metallization layer, an adhesion layer comprising titanium tungsten located over a portion of the insulation layer and the interior surface of the at least one contact channel, the adhesion layer contacting a portion of the insulation layer and a portion of the metallization layer, and a corrosion resistant layer comprising gold located over the adhesion layer.

This brief description of the invention is intended only to provide a brief overview of subject matter disclosed herein according to one or more illustrative embodiments, and does not serve as a guide to interpreting the claims or to define or limit the scope of the invention, which is defined only by the appended claims. This brief description is provided to introduce an illustrative selection of concepts in a simplified form that are further described below in the detailed description. This brief description is not intended to identify key features or essential features of the claimed subject matter, nor is it intended to be used as an aid in determining the scope of the claimed subject matter. The claimed subject matter is not limited to implementations that solve any or all disadvantages noted in the background.

### BRIEF DESCRIPTION OF THE DRAWINGS

So that the manner in which the features of the invention can be understood, a detailed description of the invention may be had by reference to certain embodiments, some of which are illustrated in the accompanying drawings. It is to be noted, however, that the drawings illustrate only certain embodiments of this invention and are therefore not to be considered limiting of its scope, for the scope of the invention encompasses other equally effective embodiments. The drawings are not necessarily to scale, emphasis generally being placed upon illustrating the features of certain embodiments of invention. In the drawings, like numerals are used to indicate like parts throughout the various views. Thus, for further understanding of the invention, reference can be made to the following detailed description, read in connection with the drawings in which:
FIG. 1 is an example cross sectional view of a bond pad of a sensor in an example embodiment of the invention;
FIG. 2 is an example process flow showing the steps in fabricating a bond pad of a sensor in an example embodiment of the invention;
FIG. 3 is an example cross sectional view of a substrate layer, a passivation layer and a metallization layer in an example embodiment of the invention;
FIG. 4 is an example cross sectional view of a substrate layer and a passivation layer with an etched metallization layer covered in an insulation layer in an example embodiment of the invention;
FIG. 5 is an example cross sectional view of a substrate layer, a passivation layer and an etched metallization layer covered in an etched insulation layer having contact channels in an example embodiment of the invention; and
FIG. 6 is an example cross sectional view of a substrate layer, a passivation layer and an etched metallization layer covered in an etched insulation layer having contact channels covered by an adhesion layer and a corrosion resistant layer in an example embodiment of the invention.

### DETAILED DESCRIPTION OF EMBODIMENTS OF THE INVENTION

A device for preventing corrosion on sensors and a method of fabricating the same is disclosed, wherein the device comprises an insulation layer and an adhesion layer covering a metallization layer of a silicon sensor with a corrosion resistant layer located over the adhesion layer. An advantage that may be realized in the practice of some embodiments of the described device and method of fabrication is that it enables the use of conventional silicon-to-glass bonding techniques, while accommodating the use of gold as the corrosion resistant layer. During fabrication, sufficient heat is required to produce a quality silicon-to-glass anodic bond. Accordingly, if the glass layer were bonded to the substrate layer through conventional techniques using a solid gold metallization layer, the heat required to create a quality anodic bond could result in diffusion of the gold into the silicon. Altering the silicon-to-glass bonding process by using a lower temperature could result in a lower quality bond. Alternatively, if the glass layer were bonded to substrate layer prior to conventional metallization using gold, presence of the gold metallization layer would exclude the use of wet processing techniques in patterning the metallization layer as the glass would be chemically incompatible with such wet processing.

A further advantage that may be realized in the practice of some embodiments of the described device and method of fabrication is that the insulation layer is not only corrosion resistant, as is the corrosion resistant layer, but it is also scratch resistant. Accordingly, use of the insulation layer can improve the overall durability of the resulting sensor, especially at bond pad junctions that are susceptible to scratching from, for example, wires or other physical connections. A still further advantage that may be realized in the practice of some embodiments of the described device and method of fabrication is that the corrosion resistant layer can be made very thin. In situations where gold is used as the corrosion resistant material, this can reduce the amount of gold needed to fabricate the sensor and reduce its overall cost, as the metallization layer can remain, for example, lower cost aluminum.

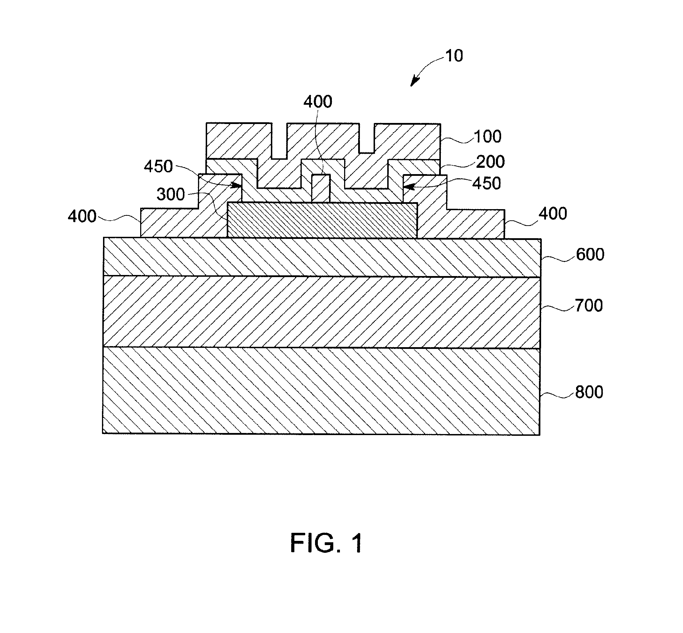

FIG. 1 shows a cross sectional view of a bond pad 10 of a sensor in an example embodiment of the invention. Bond pad 10 can provide an electrical connection between a metallization layer 300 of a silicon sensor and various external components, for example wires or contact pins. Bond pad 10 can comprise a silicon substrate layer 700 having a passivation layer 600. In one embodiment, substrate layer 700 can be a silicon wafer which can have n-type or p-type doping, and can be of a suitable thickness to meet the design and operational requirements for the silicon sensor being fabricated. Passivation layer 600 can consist of, for example, a silicon dioxide layer, a silicon nitride layer, or a combination of both. Passivation layer 600 can provide electrical insulation and protection to substrate layer 700.

Bond pad 10 can further comprise a metallization layer 300. Metallization layer 300 can provide electrical conductivity from the outer surface of the silicon sensor to the sensing elements, and can be comprised of, for example, aluminum. The metallization layer 300 can be covered by an insulation layer 400, which can comprise, for example, a layer of low temperature oxide such as scratch resistant silicon dioxide. The properties of the insulation layer 400 can be chosen such that it can be deposited over the metallization layer 300 at a relatively low temperature, for example 400 °C, such that it coats the entire exposed surface of the metallization layer 300 to prevent both corrosion and scratching of the metallization layer 300. Because the insulation layer 400 may not be electrically conductive, one or more contact channels 450 can be etched through the insulation layer 400 to provide access to the metallization layer 300 through the insulation layer 400.

Bond pad 10 can further comprise an adhesion layer 200 that can be deposited over a portion of the insulation layer 400 and into contact channels 450 such that adhesion layer 200 covers the interior surface of contact channels 450 as shown in FIG. 1. In some embodiments, adhesion layer 200 may only be deposited within the contact channels 450. Further, a corrosion resistant layer 100 can be deposited over adhesion layer 200 so that the adhesion layer 200 is located between the corrosion resistant layer 100 and the insulation layer 400 and metallization layer 300 combination, as shown in FIG. 1. Adhesion layer 200 can be comprised of, for example, a layer of titanium tungsten (TiW) or any other suitable alloy, and can act not only as an adhesion layer for the corrosion resistant layer 100, but also as a barrier to prevent the corrosion resistant layer 100 from diffusing into substrate layer 700. Adhesion layer 200 can be electrically conductive. Corrosion resistant layer 100 can be, for example, a layer of gold or other material that can be both electrically conductive and not easily corroded by environmental factors, for example high humidity or acidity. Corrosion resistant layer 100 can be placed into physical contact with external components, for example wires or contact pins (not shown), to provide electrical conductivity between bond pad 10 and the external components.

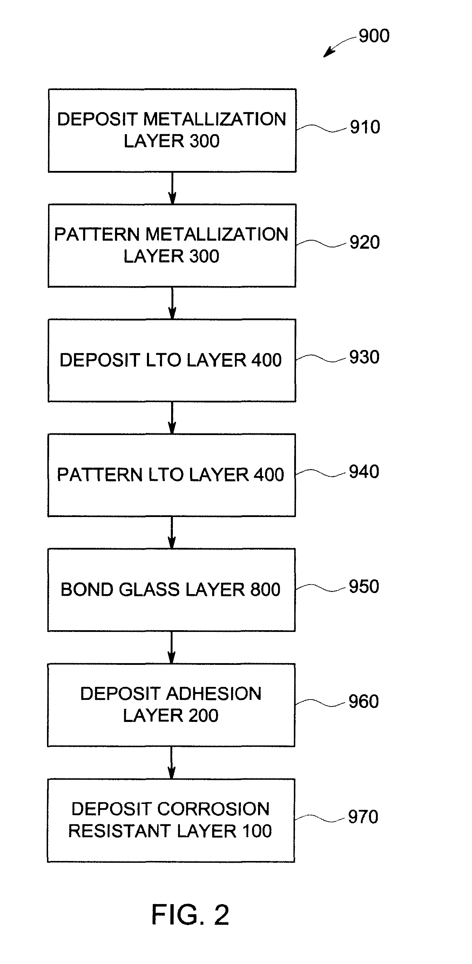

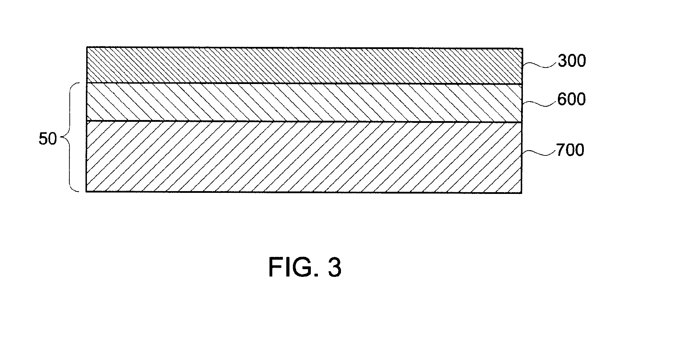

An example process for fabricating a bond pad 10 like the one illustrated in FIG. 1 is explained with reference to FIGS. 1 through 6. FIG. 2 is an example process flow 900 for fabricating a bond pad 10 of a sensor in one embodiment of the invention. FIG. 3 is an example cross sectional view of a substrate layer 700, a passivation layer 600 and a metallization layer 300 in an example embodiment of the invention. With reference to FIG. 3, in process step 910 of FIG. 2, the metallization layer 300 can be deposited onto a desired portion of a silicon wafer 50. Silicon wafer 50 can comprise a substrate layer 700 having a passivation layer 600. Substrate layer 700 can be silicon which can have n-type or p-type doping, and be of a suitable thickness to meet the design and manufacturing requirements for the silicon sensor being fabricated. Substrate layer 700 can be any device or other layer of a silicon sensor. Passivation layer 600 can consist of, for example, a silicon dioxide layer, a silicon nitride layer, or a combination of both. Passivation layer 600 can provide both electrical insulation and protection to the substrate layer 700 during manufacturing and operation. Metallization layer 300 can be deposited using sputtering or evaporation techniques, and can be comprised of, for example, aluminum. Metallization layer 300 can be deposited to any desired thickness to suit device design and fabrication requirements.

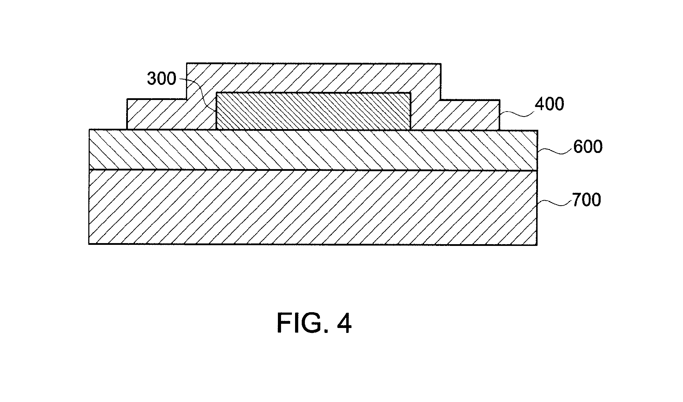

In process step 920 of FIG. 2, the metallization layer 300 is etched and patterned to meet design specifications of the silicon sensor being fabricated. Metallization layer 300 is patterned using a photoresistive mask and dry or wet etching techniques, for example DRIE, wet etching with KOH or TMAH, or the like. FIG. 4 is an example cross sectional view of a substrate layer 700 and a passivation layer 600 with an etched metallization layer 300 covered in an insulation layer 400 in an example embodiment of the invention. In process step 930 of FIG. 2, an insulation layer 400, for example a low temperature oxide such as silicon dioxide, can be deposited over the metallization layer 300 and passivation layer 600, as shown in FIG. 4. The insulation layer 400 can be deposited using low pressure chemical vapor deposition (LPCVD), which provides suitable step coverage of the metallization layer 300.

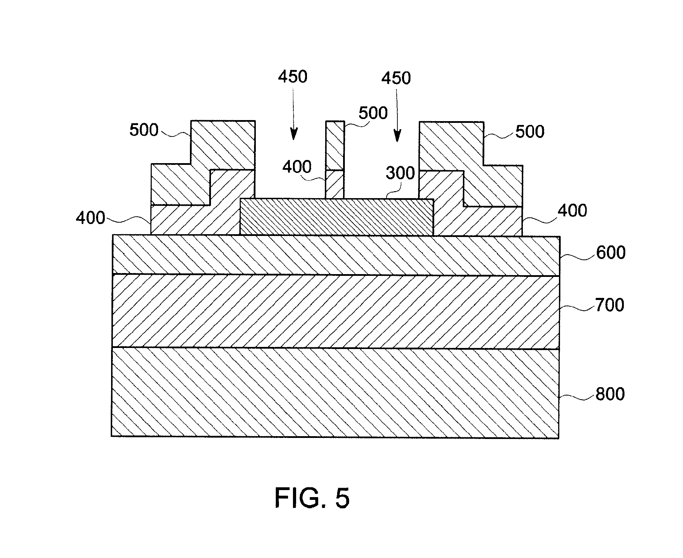

FIG. 5 is an example cross sectional view of a substrate layer 700, a passivation layer 600 and an etched metallization layer 300 covered in an etched insulation layer 400 having contact channels 450 in an example embodiment of the invention. In process step 940 of FIG. 2, the insulation layer 400 is etched and patterned, using photoresistive mask 500 and dry or wet etching techniques, for example DRIE, wet etching with KOH or TMAH, or the like, as shown in FIG. 5. The etching performed during process step 940 can remove the insulation layer 400 from the surface of the passivation layer 600 at a chosen distance from the metallization layer 300. Additionally, one or more vertical contact channels 450, which can be hollow cavities extending through the insulation layer 400 down to the metallization layer 300, can be formed using, for example, wet or dry etching techniques. Contact channels 450 can provide exposure of a portion of the metallization layer 300 through the contact channels 450.

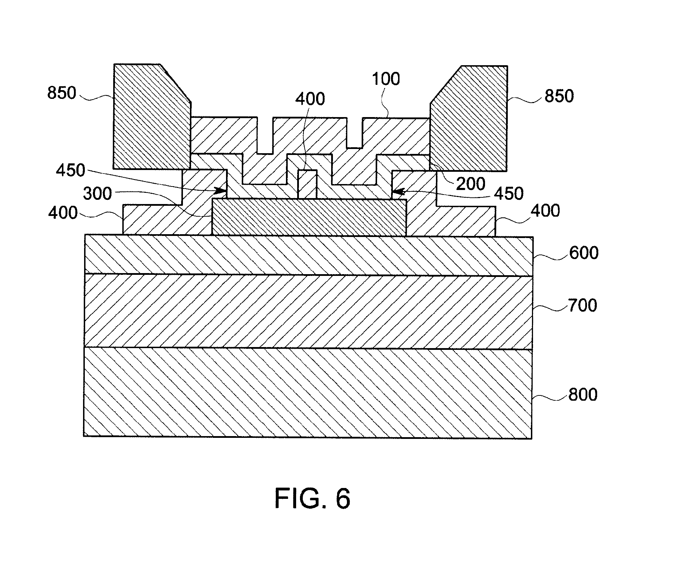

FIG. 6 is an example cross sectional view of a glass layer 800, a substrate layer 700, a passivation layer 600 and an etched metallization layer 300 covered in an etched insulation layer 400 having contact channels 450 covered by an adhesion layer 200 and a corrosion resistant layer 100 in an example embodiment of the invention. In process step 950 of FIG. 2, a glass layer 800 is bonded to the bottom side of substrate layer 700 using silicon-to-glass bonding techniques, such as anodic bonding. Glass layer 800 can isolate the silicon of substrate layer 700 from the device packaging that can surround the finished sensor.

In process step 960 of FIG. 2, a hard mask 850, for example a shadow mask, can be placed over the bond pad 10 such that an open portion of the hard mask 850 leaves a portion of the etched insulation layer 400 and the contact channels 450 exposed, as shown in FIG. 6. Once the hard mask 850 is in place, an adhesion layer 200 can be deposited using a sputter or evaporation process over the exposed portion of insulation layer 400 and the interior surface of the contact channels 450, as shown in FIG. 6. In some embodiments, adhesion layer 200 can be deposited only within the contact channels 450. Adhesion layer 200 can be comprised of, for example, a layer of titanium tungsten (TiW) or any other suitable conductive alloy, and can act not only as an adhesion layer for the corrosion resistant layer 100, but also as a barrier to prevent the corrosion resistant layer 100 from diffusing into the silicon. Adhesion layer 200 can be deposited to any thickness to meet design specifications, and can be made very thin, for example 100 Angstroms, if needed.

Finally, in process step 970 of FIG. 2, corrosion resistant layer 100 can be deposited using sputter or evaporation process over the exposed portion of adhesion layer 200 and the contact channels 450, as shown in FIG. 6. Corrosion resistant layer 100 can be comprised of, for example, a layer of gold or other corrosion resistant conductive material. Corrosion resistant layer 100 can be thin, for example on the order of 0.1 µm., but can be deposited to any thickness to meet given design parameters. Together, adhesion layer 200 and corrosion resistant layer 100 provide a conductive path from the upper surface of bond pad 10 to the metallization layer 300. The shape of adhesion layer 200 and corrosion resistant layer 100 can be dictated by the thickness of insulation layer 400 and the size, shape and number of contact channels 450. Once corrosion resistant layer 100 is deposited, hard mask 850 can be removed.

The above detailed description is provided to illustrate example embodiments and is not intended to be limiting. Although the method for fabricating a corrosion resistant sensor has been shown and described with respect to embodiments involving a bond pad, it will be apparent to those skilled in the art that similar techniques can be used to prevent corrosion on any form of silicon sensor metallization or electrical contact. Accordingly, it should be recognized that the device and method of manufacture described herein are useful in a wide variety of other applications not explicitly described herein. It will also be apparent to those skilled in the art that numerous modifications and variations within the scope of the present invention are possible. Further, numerous other materials and processes can be used within the scope of the example methods and structures described as will be recognized by those skilled in the art. Additionally, it will be apparent to those of skill in the art that the sequence of steps identified and described in various example embodiments need not occur in the sequence described, and that in other embodiments various steps can be combined, performed in different orders, either contiguously, non-contiguously, or in parallel, and still achieve the same result.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. A device for preventing corrosion on a sensor comprising:
an insulation layer (400) located over a metallization layer (300) of said sensor having a substrate layer (700) comprised of silicon;
at least one contact channel (450) extending through said insulation layer (400) to expose a portion of said metallization layer (300);
an adhesion layer (200) located over a portion of said insulation layer (400) and an interior surface of said at least one contact channel (450), said adhesion layer (200) contacting a portion of said insulation layer (400) and a portion of said metallization layer (300); and
a corrosion resistant layer (100) located over said adhesion layer (200).

2. The device of claim 1, further comprising a glass layer (800) bonded to the bottom of said substrate layer (700).

3. The device of claim 1 or claim 2, wherein said insulation layer (400) is comprised of silicon dioxide.

4. The device of claim 1, 2 or 3, wherein said metallization layer (300) is comprised of aluminum.

5. The device of any one of claims 1 to 4, wherein said corrosion resistant layer (100) is comprised of gold.

6. The device of any one of claims 1 to 5, wherein said adhesion layer (200) is comprised of titanium tungsten.

7. The device of any one of claims 1 to 6, wherein said device is at least one of: a bond pad (10) and an electrical contact.

8. A method for preventing corrosion on a sensor comprising the steps of:
depositing an insulation layer (400) over a metallization layer (300) of said sensor having a substrate layer (700) comprised of silicon;
forming at least one contact channel (450) through said insulation layer (400) to expose a portion of said metallization layer (300);
depositing an adhesion layer (200) over a portion of said insulation layer (400) and an interior surface of said at least one contact channel (450), said adhesion layer (200) contacting a portion of said insulation layer (400) and a portion of said metallization layer (300); and
depositing a corrosion resistant layer (100) over said adhesion layer (200).

9. The method of claim 8, wherein the step of forming said at least one contact channel (450) further includes the step of bonding a glass layer (800) to said substrate layer (700) of said sensor.

10. The method of claim 8 or claim 9, wherein said insulation layer (400) is comprised of silicon dioxide.

11. The method of claim 8, 9 or 10, wherein said metallization layer (300) is comprised of aluminum.

12. The method of any one of claims 8 to 11, wherein said corrosion resistant layer (100) is comprised of gold.

13. The method of any one of claims 8 to 12, wherein said adhesion layer (200) is comprised of titanium tungsten.

14. The method of any one of claims 8 to 13, wherein said step of depositing an adhesion layer (200) and said step of depositing said corrosion resistant layer (100) are performed using a hard mask and sputter process.

15. The method of any one of claims 8 to 14, wherein said step of forming said at least one contact channel is performed using a photoresistive mask and either dry etching techniques, or wet etching techniques.
